(19)

**Europäisches Patentamt**

**European Patent Office**

**Office européen des brevets**

(11) **EP 4 752 572 A1**

(12) **EUROPEAN PATENT APPLICATION**

(43) Date of publication:
**03.06.2026 Bulletin 2026/23**

(21) Application number: **24216870.6**

(22) Date of filing: **02.12.2024**

(51) International Patent Classification (IPC):
*G01R 31/08* (2020.01)

(52) Cooperative Patent Classification (CPC):
**G01R 31/085; G01R 31/088**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Hitachi Energy Ltd**
**8050 Zürich (CH)**

(72) Inventors:
• **NAIDU, Obbalareddi Demudu**
**560087 Bangalore (IN)**
• **VENKATESAN, Aarthi**
**600099 Chennai (IN)**
• **LIKHITHA, Kukkala**
**520008 Vijayawada (IN)**

(74) Representative: **Vossius & Partner**
**Patentanwälte Rechtsanwälte mbB**
**Siebertstrasse 3**
**81675 München (DE)**

(54) **METHODS, DEVICE AND STORAGE MEDIUM FOR PHASE SELECTION LOGIC FOR POWER NETWORKS**

(57) The invention relates to a method for determining a faulted phase on a power transmission line, the method comprising obtaining a voltage signal and a current signal of the transmission line, selecting, based on a magnitude of the voltage signal and a magnitude of the current signal, a process for determining a faulted phase from a group of processes, and determining a faulted phase using the selected process.

Fig. 2

## Description

### Field of the invention

The present disclosure relates to methods for performing phase selection on power networks. The disclosure also relates to a corresponding computer-readable storage medium, apparatus, and power grid.
In particular, the disclosure relates to a method for implementing an intelligent phase selection logic and a magnitude-angle-based method for phase selection.

### Technical background

In power networks, electrical transmission lines and power generation equipment must be protected against faults and consequent short circuits to prevent collapse of the network, equipment damage, and personal injury. For this, using protection relays for tripping - a process of automatically and selectively disconnecting part or parts of the power network - provides a commonly employed protection mechanism. For a successful selective tripping, the fault type information is very crucial for the protection relay. Existing fault classification methods for identifying a faulted phase or phases, i.e., phase selection, for tripping can be generally categorized as either angle-based [1-4] or magnitude-based phase selection methods [5,6]. Here, existing methods have different advantages and disadvantages.
Angle-based phase selection methods typically rely on the analysis of a zero-sequence network of the power network. However, they can be disadvantageous in medium voltage networks due to the presence of different grounding methods impacting the zero-sequence network of these power networks during fault. Angle-based methods can also be disadvantageous in weak grids where the magnitude of sequence components is relatively low Magnitude-based phase selection methods can also be negatively affected in medium voltage networks like angle-based methods. Further, magnitude-based phase selection methods are not reliable for a longer duration of time in cases with high transients and harmonics.
Therefore, there is a need for a method to address the different advantages and disadvantages of methods of the prior art.

### Summary of the invention

To address one or more of the above issues - inter alia the issue of medium voltage networks and weak grids - the present disclosure provides an adaptive and intelligent method for switching between magnitude-angle-based and angle-based phase selection methods to extract the optimum benefit from both methods.
To address one or more of the above issues - inter alia the issue of transients and harmonics - the present disclosure provides a magnitude-angle-based selection method based on apparent power information.
In an aspect, the present disclosure relates to a switching method for determining a faulted phase on a power transmission line. The method comprises obtaining a voltage signal and a current signal of the transmission line, selecting, based on a magnitude of the voltage signal and a magnitude of the current signal, a process for determining a faulted phase from a group of processes, and determining a faulted phase using the selected process.
Selecting a phase selection process based on the magnitude of the obtained voltage and current signals allows the most suitable process to be performed for determining a faulted phase.
Various embodiments may preferably implement the following features:
Preferably, selecting the process for determining a faulted phase is further based on phase angles of the voltage signal.
Preferably, the group of processes comprises a magnitude-angle-based process that is based on phase angles, magnitude of the voltage signal, and magnitude of the current signal, and further comprises an angle-based process that is based on phase angles of the voltage signal.
Preferably, the angle-based process is selected based on an angle between the negative- and zero-sequence voltage of the voltage signal and the magnitude of a zero-sequence voltage of the voltage signal, or based on an angle between the negative- and zero-sequence voltage of the voltage signal, the magnitude of a zero-sequence, negative sequence voltage of the voltage signal and zero sequence current of the current signal.
Preferably, the angle-based process is selected from a group comprising a first angle-based process for determining ground faults and a second angle-based process for phase-to-phase faults.
Preferably, the above further comprises determining whether a first condition including or consisting of

$$(-30 < \delta_V^0 < 30,$$

or

$$-150<\delta_V^0<-90,$$

or

$$90<\delta_V^0<150),$$

and

$$|V_0|>K1*V_{rated},$$

is met, wherein $\delta_V^0 = \angle V_2 - \angle V_0$, and selecting the first angle-based process when it is determined that the first condition is met.

Preferably, the above further comprises determining whether a second condition including or consisting of

$$|V_2|>K2*V_{rated},$$

and

$$|V_0|<K3*V_{rated},$$

and

$$|I_0|<K4*I_{rated}$$

is met, and selecting the second angle-based method when it is determined that the second condition is met.

Preferably, determining whether the second condition is met is performed when it is determined that the first condition is not met.

Preferably, the method further comprises determining whether a third condition is met; and selecting the magnitude-angle-based process when it is determined that the third condition is met.

Preferably, it is determined that the third condition is met when it is determined that the second condition is not met.

Preferably, all phases are determined as faulted phases when a fourth condition including or consisting of

$$|V_0|< K5*|V_{rated}|,$$

and

$$|V_2|< K6*|V_{rated}|$$

is met.

Advantageously, the above proposed switching method is capable of intelligently switching between different processes for phase selection, notably between magnitude-angle-based processes and angle-based processes based on the conditions for which a certain type of process is more suitable or optimized. Most notably, the switching method provides a phase selection even when angle values are considered to be obsolete during lower signal magnitudes. The achieved phase selection output can be used for single-pole auto-reclosing based on the determined faulted phase. Additionally, the proposed switching method is agnostic to the type of grounding.

In a further aspect, the present disclosure relates to a magnitude-angle-based method for determining a faulted phase on a power transmission line, the method comprising obtaining a voltage signal and a current signal of the transmission line, determining a change in the magnitude of the apparent power, $\Delta S$, for each phase based on the voltage and current signal, determining a fault voltage angle, and determining a faulted phase based on $\Delta S$ and the fault voltage angle.

Various embodiments may preferably implement the following features:
Preferably, determining a faulted phase comprises performing a process selected from one of a first magnitude-angle-based process for determining a ground fault, or a second magnitude-angle-based process for determining a phase-to-phase fault.

Preferably, the method further comprises determining whether a first condition including or consisting of

$$|V_0| > K7 * V_{rated},$$

or

$$|I_0| > K8 * I_{rated}$$

is met, and selecting the first magnitude-angle-based process when the first condition is met, or selecting the second magnitude-angle-based process when the first condition is not met.

Preferably, the fault voltage angle is determined based on the negative-sequence voltage of the voltage signal, the positive-sequence voltage signal, and the pre-fault positive-sequence voltage of the voltage signal.

Preferably, the fault angle, $\delta_V^+$, is determined as $\delta_V^+ = \angle V_2 - \angle \Delta V_1$, wherein $\Delta V_1 = V_1^f - V_1^{\text{pre fault}}$, wherein $V_1^f$ is the positive-sequence fault voltage, and $V_1^{\text{pre}}$ is the positive-sequence pre-fault voltage.

Preferably, the first angle-and-magnitude-based process comprises one or more of:

determining an A-g fault when $(\Delta S_A < \Delta S_B)$ and $(\Delta S_A < \Delta S_C)$ and $(-90 < \delta_V^+ < 30)$;

determining a B-g fault when $(\Delta S_B < \Delta S_A)$ and $(\Delta S_B < \Delta S_C)$ and $(30 < \delta_V^+ < 150)$;

determining a C-g fault when $(\Delta S_C < \Delta S_A)$ and $(\Delta S_C < \Delta S_B)$ and $(-180 < \delta_V^+ < -90)$ or $(150 < \delta_V^+ < 180)$);

determining an AB-g fault when $(\Delta S_A < \Delta S_C)$ and $(\Delta S_B < \Delta S_C)$ and $(-30 < \delta_V^+ < 90)$;

determining a BC-g fault when $(\Delta S_B < \Delta S_A)$ and $(\Delta S_C < \Delta S_A)$ and ( $(-180 < \delta_V^+ < -150)$ or $(90 < \delta_V^+ < 180)$ ); and/or

determining a CA-g fault when $(\Delta S_C < \Delta S_B)$ and $(\Delta S_A < \Delta S_B)$ and $(-150 < \delta_V^+ < -30)$.

Preferably, the second angle-and-magnitude-based process comprises one or more of:

determining an AB fault when $(\Delta S_A < \Delta S_C)$ and $(\Delta S_B < \Delta S_C)$ and $(-30 < \delta_V^+ < 90)$;

determining a BC fault when $(\Delta S_B < \Delta S_A)$ and $(\Delta S_C < \Delta S_A)$ and ( $(-180 < \delta_V^+ < -150)$ or $(90 < \delta_V^+ < 180)$ ); and/or

determining a CA fault when $(\Delta S_C < \Delta S_B)$ and $(\Delta S_A < \Delta S_B)$ and $(-150 < \delta_V^+ < -30)$.

Preferably, in the switching method for determining a faulted phase on a power transmission line, the magnitude-angle-based method is the magnitude-angle-based method as described above.

Advantageously, the above proposed magnitude-angle-based method is simple to implement as it requires only local voltage and current measurements available at a node such as a relay terminal and does not require communication. Furthermore, the proposed magnitude-angle-based method is agnostic to the type of power source such as, e.g. an IBR source and its control strategy. The proposed magnitude-angle-based method is also agnostic of the type of the grounding.

In a further aspect, the present disclosure relates to a computer program product comprising instructions which, when executed by a processor of computer, cause the computer to carry out the method of any one of the embodiments.

In yet a further aspect, the present disclosure relates to a non-transitory computer-readable medium comprising a computer program product as described above.

In yet a further aspect, the present disclosure relates to an apparatus comprising a processor and a non-transitory computer-readable medium as described above.

Other aspects, features, and advantages will be apparent from the summary above, as well as from the description that follows, including the figures and the claims.

Embodiments of the present disclosure will now be described by way of example only and with reference to the following accompanying drawings. In the figures, the same reference numerals denote the same or similar elements.

**Brief description of the drawings**

Fig. 1 shows a schematic illustration of a power network according to embodiments of the present disclosure.

Fig. 2 shows a flow chart illustrating a switching method according to embodiments of the present disclosure.

Fig. 3 shows a flow chart illustrating a further switching method according to embodiments of the present disclosure.

Fig. 4A and Fig. 4B respectively show flow charts illustrating angle-based processes for phase selection according to embodiments of the present disclosure.

Fig. 5 shows a flow chart illustrating a magnitude-angle-based process according to embodiments of the present disclosure.

Figs. 6A to 6D show obtained measurement signals and signal magnitudes for a magnitude-angle-based process according to embodiments of the present disclosure.

Figs. 7A to 7D show obtained measurement signals and signal magnitudes for a magnitude-angle-based process according to embodiments of the present disclosure.

Figs 8A and to 8D show obtained measurement signals and signal magnitudes for a magnitude-angle-based process according to embodiments of the present disclosure.

Figs. 9A to 9F show obtained measurement signals, signal magnitudes, and signal angles for a combination of a switching method according to embodiments of the present disclosure.

Figs. 10A to 10G show obtained measurement signals, signal magnitudes, and signal angles for a combination of a switching method according to further embodiments of the present disclosure.

Figs. 11A to 11D show obtained measurement signals, signal magnitudes, and signal angles for a combination of a switching method according to yet further embodiments of the present disclosure.

## Detailed description

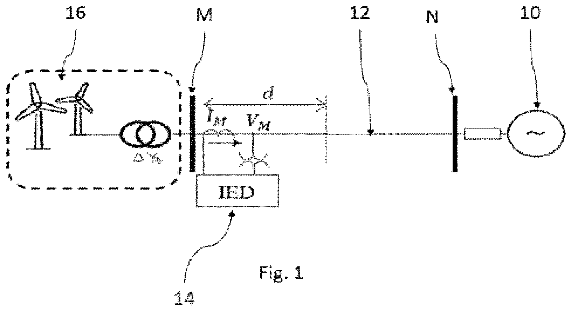

**Fig. 1** illustrates an exemplary power network or potion of a power network according to embodiments of the present disclosure. The power network comprises one or more power sources 16. In preferred embodiments, the power sources are inverter-based resources, IBRs, such as wind-turbines or solar panels. The one or more powers sources are typically connected to a power grid 10 via a transmission line 12, wherein the transmission line 12 is configured to carry three-phase electrical signals. Electrical signals may be obtained at node M and/or at node N, wherein a measurement sensor, a relay, or other suitable device may be used to obtain electrical signals. An intelligent electronic device, IED, may be provided for various management and control functions of the transmission line 12 or power network. Notably, proposed methods of the present disclosure may be implemented by an IED provided on the transmission line 12. Generally, a node may be, but is not limited to, a power source, substation, terminal, or bus. For example, node M may be a local end of a power transmission line, and node N may be a remote end of the power transmission line.

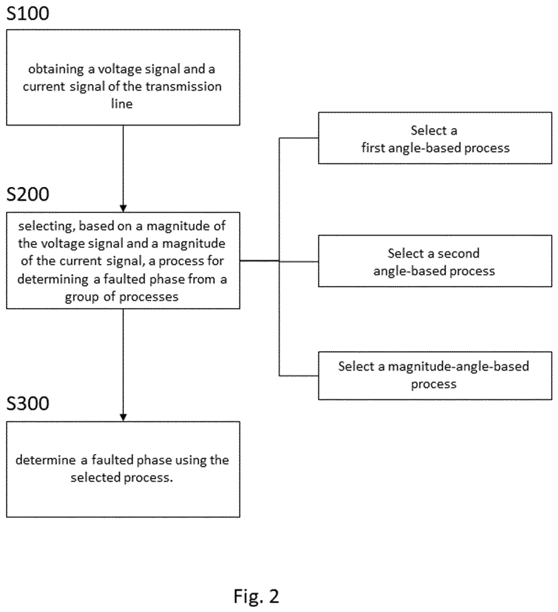

**Fig. 2** shows a flowchart illustrating a switching method according to embodiments of the present disclosure.

In step S100, a voltage signal and a current signal of the transmission line 12 are obtained. Here obtained can mean directly measured, deduced from related measurement(s), or received as data from a further device or entity. The signals may be measured at any one of node M or node N as shown in Fig, 1, but may be measured at any suitable position on the transmission line 12 using devices and methods readily available to the skilled person.

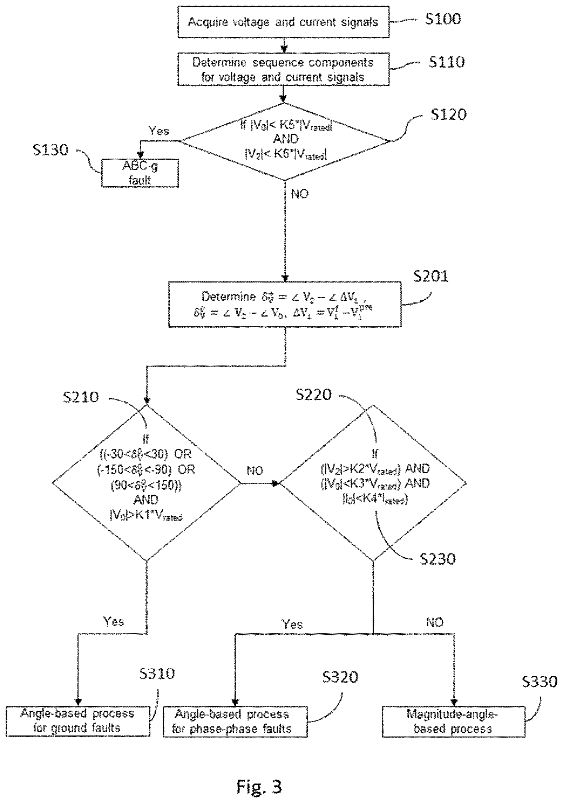

In step S200, based on the obtained voltage and current signals of the transmission line, a process for phase selection, i.e., a process for determining a faulted phase, is selected from among of group of different processes. Notably, processes of the group of different processes may differ from each other by type (e.g., magnitude-angle-based or angle-based processes for phase selection), and/or by type of required input data. In embodiments, step S200 may comprise a step where a first angle-based phase selection process is selected based on certain conditions. Additionally, or alternatively, step S200 may comprise a step where a second angle-based phase selection process is selected based on certain conditions. Additionally, or alternatively, step S200 may comprise a step where a magnitude-angle-based process for phase selection is selected based on certain conditions. Conditions for determining a most suitable process based on available input data, indicative of a state of the transmission line 12, will be described in more detail below, notably in the context of embodiments of Fig. 3.

**Fig. 3** shows a flowchart illustrating a further switching method according to more detailed embodiments of switching methods described within the context of embodiments of Fig. 2.

As before, in step S100, a voltage signal and a current signal of the transmission line are obtained.

In step S110, sequence components, i.e., positive-, negative-, and zero-sequence components for the obtained voltage and current signals are determined.

A step S120 may be performed for determining an ABC-g fault. Such a fault is determined if a condition of

$$|V_0| < K5^* |V_{rated}| \ \text{and} \ |V_2| < K6^* |V_{rated}|$$

is met.

The subscript indices 0, 1, 2 respectively denote zero-, positive-, and negative-sequence components. Scalar factors K5 and K6 may be set and adjusted as required. In embodiments, K5 and/or K6 can be set as 0.02.

In case the above condition is not met, the proposed method may proceed to step S201, where angles

$$\delta_V^+ = \angle V_2 - \angle \Delta V_1 \ \text{and} \ \delta_V^0 = \angle V_2 - \angle V_0 \ \text{are determined, wherein} \ \Delta V_1 = V_1^f - V_1^{pre}.$$

Based on the determined angles, in step S210, it is determined whether a condition of

$$((-30 < \delta_V^0 < 30) \ \text{OR} \ (-150 < \delta_V^0 < -90) \ \text{OR} \ (90 < \delta_V^0 < 150))$$

AND

$$|V_0| > K1^* V_{rated}$$

is met. Scalar factor K1 may be set and adjusted as required. In embodiments, K1 can be set as 0.05.

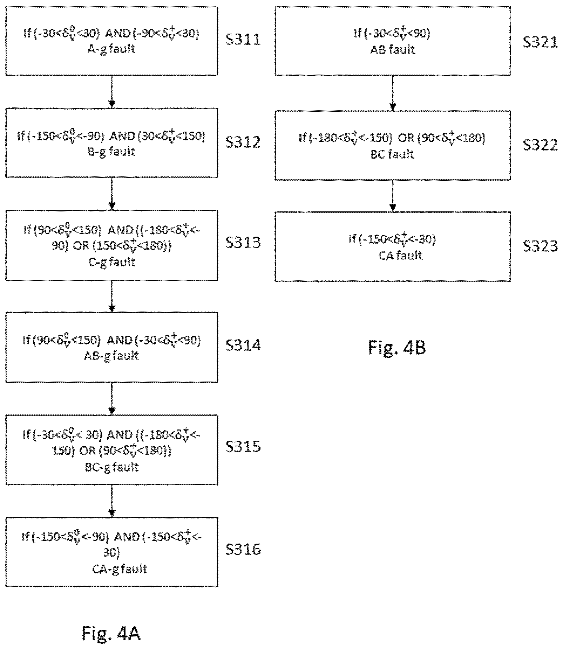

If the condition is satisfied, the method may proceed to step S310, where a first angle-based process for phase selection is selected and performed. Here, the first angle-based process may be an angle-based process for ground faults. Such an angle-based process for ground faults is described below in the context of Fig. 4A.

If the condition is not met, the method may proceed to step S220, where it is determined whether a condition of

$$(|V_2| > K2^* V_{rated}) \ \text{AND} \ (|V_0| < K3^* V_{rated}) \ \text{AND} \ (|I_0| < K4^* I_{rated})$$

is met. Scalar factors K2, K3, and/or K4 may be set and adjusted as required. In embodiments, any one of K2, K3, and K4 may be set as 0.05, 0.05 and 0.15 respectively.

If the condition is met, the method may proceed to step S320, where a second angle-based process for phase selection is selected and performed. Here, the second angle-based process may be an angle-based process for phase-phase faults. Such an angle-based process for phase-phase faults is described below in the context of Fig. 4B.

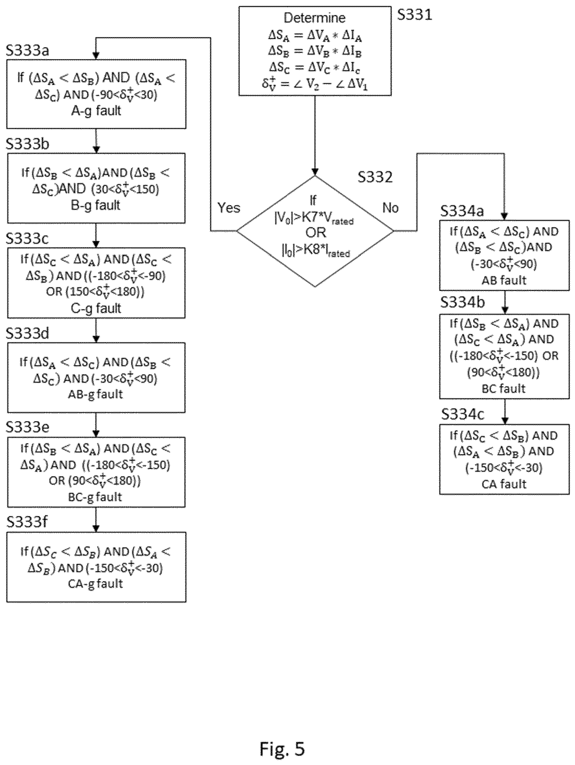

If the condition is not satisfied, the method may proceed to step S330, where a magnitude-angle-based process for phase selection is selected. Here, the magnitude-angle-based process may preferably be a method as described below in the context of Figs. 5 to 8D.

**Fig. 4A** illustrates an angle-based process for phase selection according to embodiments of the present disclosure. Notably, according to an angle-based process for ground faults, the following steps may be performed. While Fig. 4A illustrates an order of steps, the order of steps may be changed as required by the skilled person.

In step S311, an A-g fault is determined if the condition of

$$(-30 < \delta_V^0 < 30) \ \text{AND} \ (-90 < \delta_V^+ < 30)$$

is met.

If the condition is not met, in step S312, a B-g fault is determined if the condition of

$$(-150 < \delta_V^0 < -90) \ \text{AND} \ (30 < \delta_V^+ < 150)$$

is met.

If the condition is not met, in step S313, a C-g fault is determined if the condition of $(90 < \delta_V^0 < 150)$ AND ( $(-180 < \delta_V^+ < -90)$ OR $(150 < \delta_V^+ < 180)$ is met.

If the condition is not met, in step S314, an AB-g fault is determined if the condition of $(90 < \delta_V^0 < 150)$ AND ( $(-30 < \delta_V^+ < 90)$ is met.

If the condition is not met, in step S315, a BC-g fault is determined if the condition of $(-30 < \delta_V^0 < 30)$ AND ( $(-180 < \delta_V^+ < -150)$ OR $(90 < \delta_V^+ < 180)$ ) is met.

If the condition is not met, in step S316, a CA-g fault is determined if the condition of $(-150 < \delta_V^0 < -90)$ AND $(-150 < \delta_V^+ < -30)$ is met.

**Figs. 4B** illustrates an angle-based process for phase selection according to embodiments of the present disclosure. Notably, according to an angle-based process for phase-phase faults, the following steps may be performed. While Fig. 4B illustrates an order of steps, the order of steps may be changed as required by the skilled person.

In step S321, an AB fault is determined if the condition of

$$(-30 < \delta_V^+ < 90)$$

is met.

If the condition is not met, in step S322, a BC fault is determined if the condition of $(-180 < \delta_V^+ < -150)$ OR $(90 < \delta_V^+ < 180)$ is met.

If the condition is not met, in step S323, a CA fault is determined if the condition of

$$(-150 < \delta_V^+ < -30)$$

is met.

Notably, the angle-based processes illustrated in Figs. 4A and 4B are further described in detail in patent application WO 2024/068103 A1. The content of WO 2024/068103 A1 is hereby incorporated by reference in its entirety.

**Fig. 5** illustrates a magnitude-angle-based process for phase selection according to embodiments of the present disclosure. Notably, the magnitude-angle-based process may be a method as described for step S330 described within the context of embodiments of Fig. 3. Notably, the process may be performed on a power network or part of a power network as described within the context of embodiments of Fig. 1.

For step S331, considering voltage and current signal measurements at node M as shown in Fig. 1, the absolute change in magnitude of voltage for each phase can be expressed as in (1).

$$\Delta V_A = \left| V_A^f \right| - \left| V_A^{pre} \right|$$

$$\Delta V_B = \left| V_B^f \right| - \left| V_B^{pre} \right| \tag{1}$$

$$\Delta V_C = \left| V_C^f \right| - \left| V_C^{pre} \right|$$

where, $\Delta V_A, \Delta V_B, \Delta V_C$ are the change in voltage magnitude. $\left| V_A^f \right|, \left| V_B^f \right|, \left| V_C^f \right|$ are the voltage magnitude for each phase during fault, and $\left| V_A^{pre} \right|, \left| V_B^{pre} \right|, \left| V_C^{pre} \right|$ are the voltage magnitude for each phase during pre-fault.

Similarly, the absolute change in the magnitude of current for each phase can be expressed as in (2).

$$\Delta I_A = \left| I_A^f \right| - \left| I_A^{pre} \right|$$

$$\Delta I_B = \left| I_B^f \right| - \left| I_B^{pre} \right| \tag{2}$$

$$\Delta I_C = \left| I_C^f \right| - \left| I_C^{pre} \right|$$

wherein $\Delta I_A, \Delta I_B, \Delta I_C$ are the change in current magnitude. $\left| I_A^f \right|, \left| I_B^f \right|, \left| I_C^f \right|$ are the magnitude of current for each phase

during fault, and $|I_A^{pre}|$, $|I_B^{pre}|$, $|I_C^{pre}|$ are the magnitude of current for each phase during pre-fault.

During pre-fault conditions, the change in voltage and current magnitude can be assumed to be zero. During fault condition, the change in voltage is negative, i.e., the voltage of the faulted phase decreases, and the change in current is positive, i.e., the current of faulted phase increases, for the faulted phase. Though these changes occur, they are often not be sufficiently significant in some cases. For instance, there are cases where the change in voltage is sufficiently significant for, e.g., IBR-connected systems, but the change in current magnitude is not sufficiently significant due to converter controls. Moreover, there are cases where the change in voltage is not sufficiently significant for high-impedance grounding systems and the change in current magnitude is more significant.

To this end, the proposed magnitude-angle-based process is based on an absolute change in apparent power, which can be determined as in (3).

$$\Delta S_A = \Delta V_A * \Delta I_A$$

$$\Delta S_B = \Delta V_B * \Delta I_B \qquad\qquad (3)$$

$$\Delta S_C = \Delta V_C * \Delta I_C$$

where, $\Delta S_A$, $\Delta S_B$, $\Delta S_C$ are the change in apparent power magnitude.

In step S332, it is determined whether a condition of $|V_0|>K7*V_{rated}$ OR $|I_0|>K8*I_{rated}$ is met. Scalar factors K7 and/or K8 can generally be set as required. In embodiments, scalar factor K7 can be set as 0.02, and/or scalar factor K8 can be set as 0.15.

If the condition is met, the proposed process proceeds to steps for determining ground faults. While Fig. 5 illustrates an order of steps S333a to S333f, the order of steps may be changed as required by the skilled person.

In step S333a, an A-g fault is determined if the condition of $(\Delta S_A < \Delta S_B)$ AND $(\Delta S_A < \Delta S_C)$ AND $(-90<\delta_V^+<30)$ is met.

If the condition is not met, in step S333b, a B-g fault is determined if the condition of $(\Delta S_B < \Delta S_A)$ AND $(\Delta S_B < \Delta S_C)$ AND $(30<\delta_V^+<150)$ is met.

If the condition is not met, in step S333c, a C-g fault is determined if the condition of $(\Delta S_C < \Delta S_A)$ AND $(\Delta S_C < \Delta S_B)$ AND ( $(-180<\delta_V^+<-90)$ OR $(150<\delta_V^+<180)$ ) is met.

If the condition is not met, in step S333d, an AB-g fault is determined if the condition of $(\Delta S_A < \Delta S_C)$ AND $(\Delta S_B < \Delta S_C)$ AND $(-30<\delta_V^+<90)$ is met.

If the condition is not met, in step S333e, a BC-g fault is determined if the condition of $(\Delta S_B < \Delta S_A)$ AND $(\Delta S_C < \Delta S_A)$ AND ( $(-180<\delta_V^+<-150)$ OR $(90<\delta_V^+<180)$ ) is met.

If the condition is not met, in step S333f, a CA-g fault is determined if the condition of $(\Delta S_C < \Delta S_B)$ AND $(\Delta S_A < \Delta S_B)$ AND $(-150<\delta_V^+<-30)$ is met.

If, in step S332, it is determined that the specified condition is not met, the process proceeds to steps for determining phase-to-phase faults. While Fig. 5 illustrates an order of steps S334a to S334c, the order of steps may be changed as required by the skilled person.

In step S334a, an AB fault is determined if the condition of $(\Delta S_A < \Delta S_C)$ AND $(\Delta S_B < \Delta S_C)$ AND $(-30<\delta_V^+<90)$ is met.

If the condition is not met, in step S334b, a BC fault is determined if the condition of $(\Delta S_B < \Delta S_A)$ AND $(\Delta S_C < \Delta S_A)$ AND ( $(-180<\delta_V^+<-150)$ OR $(90<\delta_V^+<180)$ ) is met.

If the condition is not met, in step S334c, a CA fault is determined if the condition of $(\Delta S_C < \Delta S_B)$ AND $(\Delta S_A < \Delta S_B)$ AND $(-150<\delta_V^+<-30)$ is met.

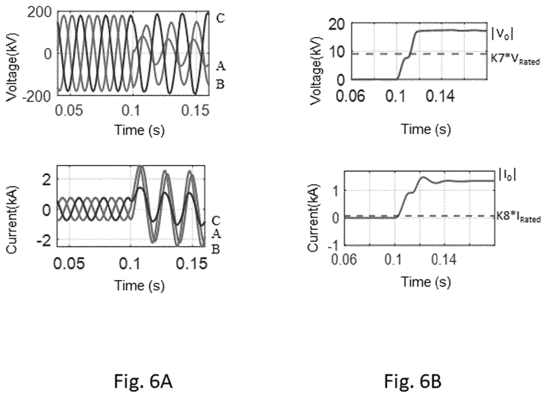

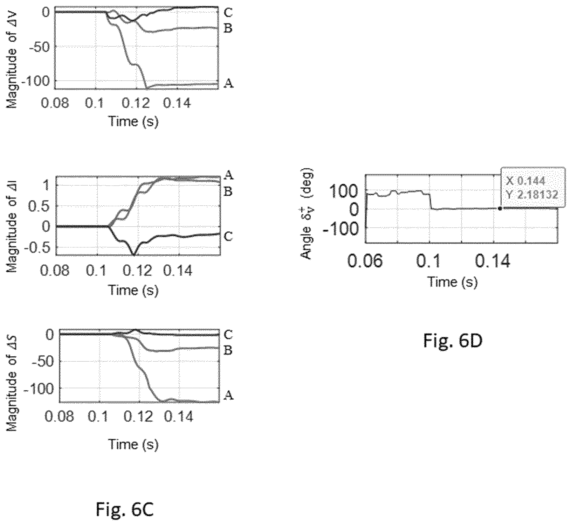

An example case 1 demonstrates the above specified magnitude-angle-based process for an A-g fault at 30% of the length of the transmission line from node M illustrated in Fig. 1. The plots of voltage and current signals measured by a relay at node M are shown in Fig. 6A. The plots of magnitude of the zero-sequence voltage and zero-sequence current are respectively shown in **Fig. 6B.** The plots of change in magnitude of voltage, current and apparent power for each phase are shown in **Fig. 6C.** The plot of the angle $\delta_V^+$ is shown in **Fig. 6D.**

It can be seen from Fig. 6B that the magnitude of the zero-sequence voltage $|V_0|$ is larger than scalar factor K7 multiplied with the rated voltage $V_{rated}$. Here, scalar factor K7 is set as 0.02 for illustrative purposes. Also, alternatively, it can also be observed from Fig. 6B that the magnitude of the zero-sequence current $|I_0|$ is larger than scalar factor K8 multiplied with the rated current $I_{rated}$. Here, scalar factor K8 is set as 0.15 for illustrative purposes. $V_0$ and $I_0$ are respectively shown as solid lines, and K7*$V_{rated}$ and K8*$V_{rated}$ are respectively shown as dashed lines in Fig. 6B. As described for step S332 in Fig. 5, since the specified condition is met, the process proceeds to any one of steps 333a to 333f for determining a ground fault.

It can be observed from Fig. 6C that the change in apparent power for phase A is less than the change in apparent power of phase B and of phase C, i.e., $\Delta S_A < \Delta S_B$ and $\Delta S_A < \Delta S_C$. Additionally, it can be observed from Fig. 6D that the angle $\delta_V^+$ is between -90 and 30 degrees.

As described for step S333a in the context of Fig. 5, this indicates that the fault is an A-g fault.

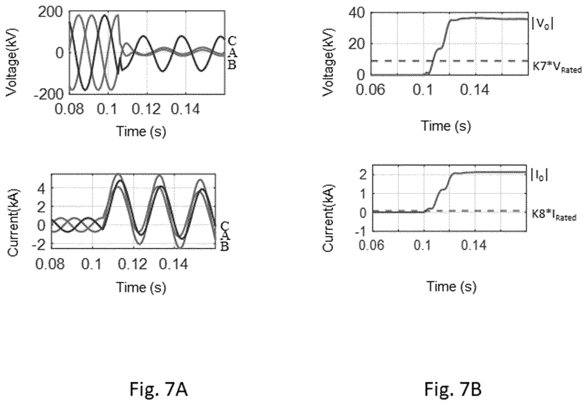

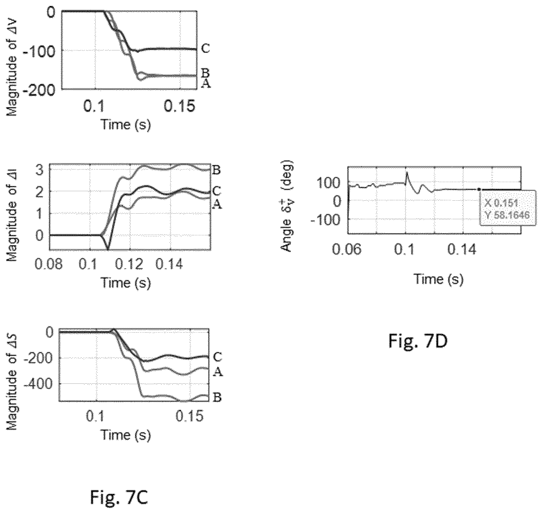

An example case 2 demonstrates the above specified magnitude-angle-based process for an AB-g fault at 5% of the length of the transmission line from node M. The plots of voltage and current signals measured by a relay at node M are shown in **Fig. 7A.** The plots of magnitude of the zero-sequence voltage and zero-sequence current are respectively shown in **Fig. 7B.** The plots of change in magnitude of voltage, current and apparent power for this case for each phase are shown in **Fig. 7C.** The plot of the angle $\delta_V^+$ is shown in **Fig. 7D.**

It can be observed from Fig. 7B that the magnitude of the zero-sequence voltage $|V_0|$ is larger than scalar factor K7 multiplied with the rated voltage $V_{rated}$. Here, scalar factor K7 is set as 0.02 for illustrative purposes. Also, alternatively, it can also be observed from Fig. 7B that the magnitude of the zero-sequence current $|I_0|$ is larger than scalar factor K8 multiplied with the rated current $I_{rated}$. Here, scalar factor K8 is set as 0.15 for illustrative purposes. $V_0$ and $I_0$ are respectively shown as solid lines, and K7*$V_{rated}$ and K8*$V_{rated}$ are respectively shown as dashed lines in Fig. 7B. As described for step S332 in Fig. 5, since the specified condition is met, the process proceeds to any one of steps 333a to 333f for determining a ground fault.

It can be observed from Fig. 7C that the change in apparent power for phase C is greater than the change in apparent power of phase A and of phase B, i.e., $\Delta S_A < \Delta S_C$ and $\Delta S_B < \Delta S_C$.

Additionally, it can be observed from Fig. 7D that the angle $\delta_V^+$ is between -30 and 90 degrees. As described for step S333d in the context of Fig. 5, this indicates that the fault is an AB-g fault.

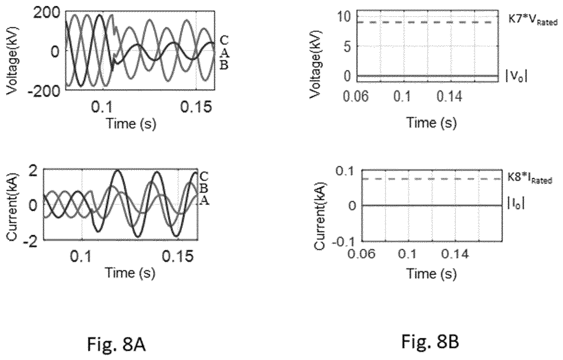

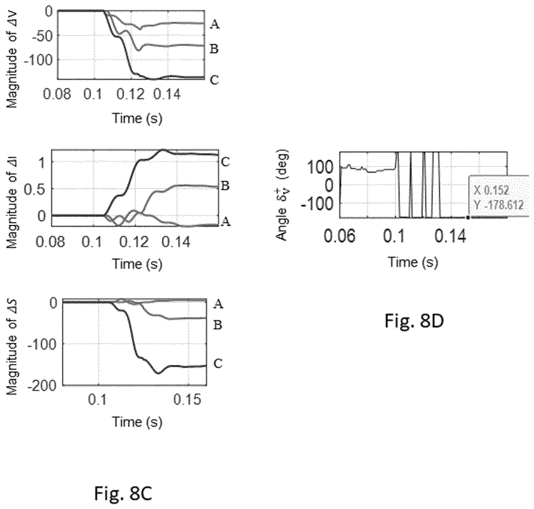

An example case 3 demonstrates the above specified magnitude-angle-based process for a BC fault at 50% of the length of the transmission line from node M. The plots of voltage and current signals measured by a relay at node M are shown in **Fig. 8A.** The plots of magnitude of the zero-sequence voltage and zero-sequence current are respectively shown in **Fig. 8B.** The plots of change in magnitude of voltage, current and apparent power for this case for each phase are shown in **Fig. 8C.** The plot of the angle $\delta_V^+$ is shown in **Fig. 8D.**

It can be observed from Fig. 8B that the magnitude of the zero-sequence voltage $|V_0|$ is smaller than scalar factor K7 multiplied with the rated voltage $V_{rated}$. Here, scalar factor K7 is set as 0.02 merely for illustrative purposes. Also, alternatively, it can also be observed from Fig. 8B that the magnitude of the zero-sequence current $|I_0|$ is smaller than scalar factor K8 multiplied with the rated current $I_{rated}$. Here, scalar factor K8 is set as 0.15 merely for illustrative purposes. $V_0$ and $I_0$ are respectively shown as solid lines, and K7*$V_{rated}$ and K8*$V_{rated}$ are respectively shown as dashed lines in Fig. 8B. As described for step S332 in Fig. 5, since the specified condition is not met, the process proceeds to any one of steps 334a to 334c for determining a phase-phase fault.

It can be observed from Fig. 8C that the change in apparent power of phase A is greater than change in apparent power of phase B and of phase C, i.e., $\Delta S_B < \Delta S_A$ and $\Delta S_C < \Delta S_A$. Additionally, it can be observed from Fig. 8D that the angle $\delta_V^+$ is between -180 and -150 degrees.

As described for step S334b in the context of Fig. 5, this indicates that the fault is a BC fault.

An example case 4 demonstrates the above specified switching method and angle-based method for an A-g fault at 30% of the length of the transmission line from node M, i.e., the same conditions as for example case 1.

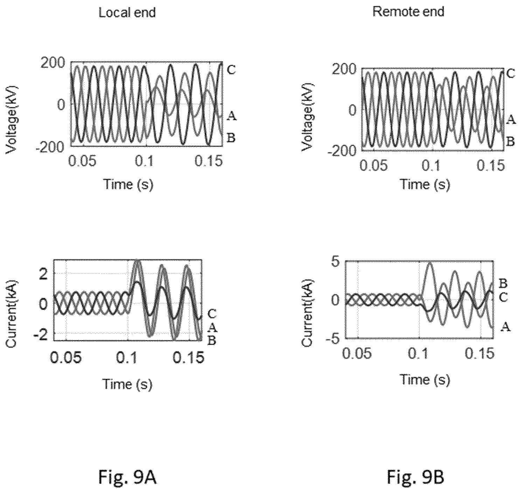

In step S100, voltage and current signals are obtained. **Fig. 9A** illustrates the obtained signals at a local end, i.e., an end of the transmission line at/near the power source 16 as illustrated in Fig. 1. **Fig. 9B** illustrates the obtained signals at a remote end, i.e., and end of the transmission line at/near the power grid 10.

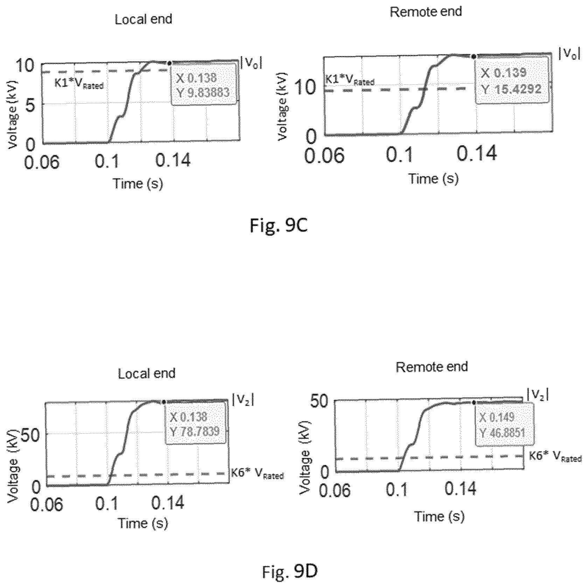

In step S110, sequence components of the obtained signals are determined. **Fig. 9C** illustrates the determined magnitude of the zero-sequence voltage at the local end and remote end, and **Fig. 9D** illustrates the determined magnitude of the negative-sequence voltage at the local end and remote end. It is to be noted that, for the following examples, measurements at both local and remote ends are shown for illustrative purposes only. Notably, measurements at the local end only are sufficient for the present invention.

In step S120, it is determined whether the conditions for an ABC-g fault as illustrated in the flow chart of Fig. 3 is met. From **Figs. 9C and 9D** it can be seen that the condition of

$$|V_0| < K5 * |V_{rated}| \text{ AND } (|V_2| < K6 * |V_{rated}|)$$

is not met, wherein, for illustrative purposes, scalar factors K5 and K6 are set as 0.02, and K1 is set as 0.05. $V_0$ and $V_2$ are respectively shown as solid lines, and $K1*V_{rated}$ and $K6*V_{rated}$ are respectively shown as dashed lines in Figs. 9C and 9D.

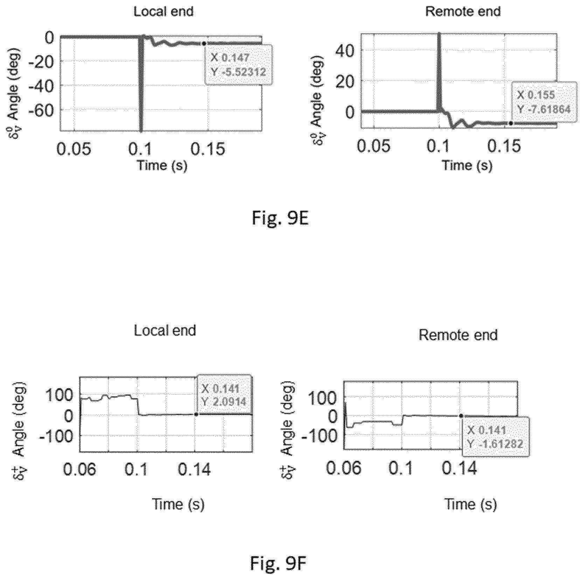

Hence it is determined that no ABC-g is present, and the process proceeds to step 201 where the respective voltage angles as illustrated in the flowchart of Fig. 3 are determined. **Fig. 9E** illustrates respective plots for $\delta_V^0$ at the local end and the remote end. **Fig. 9F** illustrates $\delta_V^+$ at the local end and at the remote end.

Next, in step S210, it is determined whether the condition

$$((-30<\delta_V^0<30) \text{ OR } (-150<\delta_V^0<-90) \text{ OR } (90<\delta_V^0<150)) \text{ AND } |V_0|>K1*V_{rated}$$

is met, wherein scalar factor K1 is set as 0.05.

As can be seen from Fig. 9E that, for both local and remote ends, $\delta_V^0$ is in the range ([-30°,30°]) of the above condition. Additionally, as can be seen in Fig. 9C, $|V_0|$ is larger than $K1*V_{rated}$, wherein K1 is set as 0.05. The condition as specified in step S210 is thus met, and the process proceeds to step S310 where an angle-based process for ground faults as illustrated in Fig.4A is selected.

As can be seen in Fig. 9F, for both local and remote ends, $\delta_V^+$ is in the range of [-90°,30°]. Hence, the condition as specified in step S311 in Fig. 4A is met, and the fault is classified as an A-g fault.

An example case 5 demonstrates the above specified switching method and magnitude-angle-based and angle-based method for an AB-g fault at 5% of the length of the transmission line from node M, i.e., the same conditions as for example case 2.

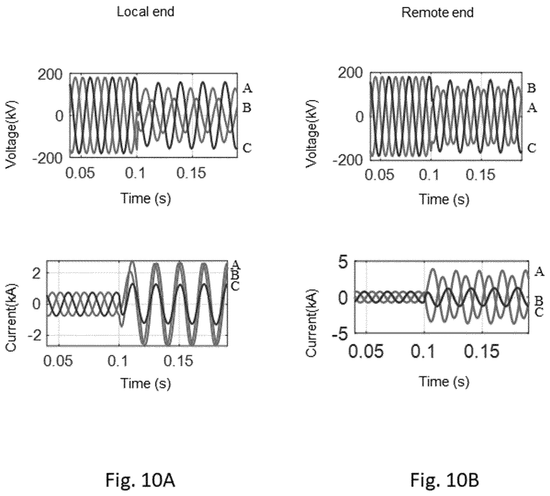

In step S100, voltage and current signals are obtained. **Fig. 10A** illustrates the obtained signals at a local end, i.e., an end of the transmission line at/near the power source 16 as illustrated in Fig. 1. **Fig. 10B** illustrates the obtained signals at a remote end, i.e., and end of the transmission line at/near the power grid 10.

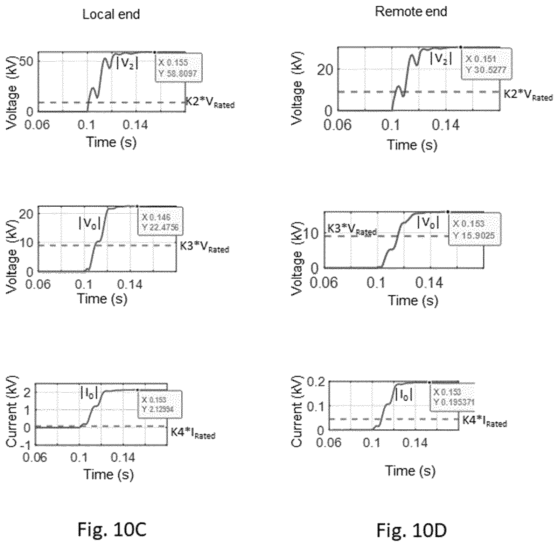

In step S110, sequence components of the obtained signals are determined. **Fig. 10C** illustrates the respectively determined magnitudes of the negative-sequence voltage, of the zero-sequence voltage, and of the zero-sequence current at the local end, and **Fig. 10D** illustrates the respectively determined magnitudes of the negative-sequence voltage, of the zero-sequence voltage, and of the zero-sequence current at the remote end.

In step S120, it is determined whether the conditions for an ABC-g fault as illustrated in the flow chart of Fig. 3 is met. From Figs. 10C and 10D it can be seen that the condition of

$$|V_0| < K5 * |V_{rated}| \text{ AND } |V_2| < K6 * |V_{rated}|$$

is not met, wherein, for illustrative purposes, scalar factors K5 and K6 are set as 0.02, and K2 is set as 0.05, K3 is set as 0.05, and K4 is set as 0.15. $V_2$, $V_0$ and $I_0$ are respectively shown as solid lines, and $K2*V_{rated}$, $K3*V_{rated}$, and $K4*I_{rated}$ are respectively shown as dashed lines in Figs. 10C and 10D.

Hence it is determined that no ABC-g is present, and the process proceeds to step 201 where the respective voltage angles as illustrated in the flowchart of Fig. 3 are determined.

Next, in step S210, it is determined whether the condition

$$((-30<\delta_V^0<30) \text{ OR } (-150<\delta_V^0<-90) \text{ OR } (90<\delta_V^0<150)) \text{ AND } |V_0|>K1*V_{rated}$$

is met, wherein, for illustrative purposes, scalar factor K1 is set as 0.05.

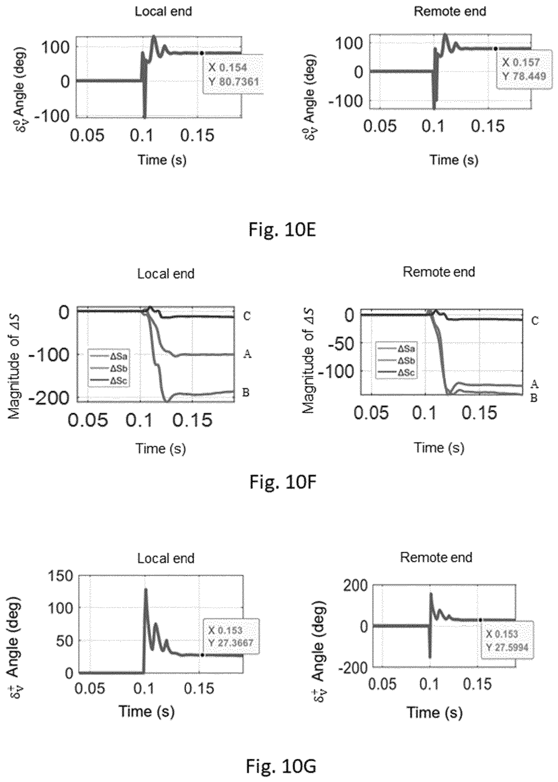

**Fig. 10E** illustrates respective plots for $\delta_V^0$ at the local end and the remote end. As can be seen, for both local and remote ends, $\delta_V^0$ is not in one of the desirable ranges ([-30°,30°], [-150, -90] or [90°, 150°]).

The process then proceeds to step S220, where it is determined whether the condition of

$$(|V_2|>K2*V_{rated}|) \text{ AND } (|V_0|<K3*V_{rated}) \text{ AND } (|I_0|<K4*I_{rated})$$

is met, wherein, for illustrative purposes, K2 is set as 0.05, K3 is set as 0.05, and K4 is set as 0.15. As can be seen from Figs. 10C and 10D, the values for $|V_0|$ and $|I_0|$ do not satisfy the condition specified in step S220.

Thus, the process proceeds to step S330, where a magnitude-angle-based process illustrated in Fig. 5 is selected.

In step S331 illustrated in Fig. 5, $\Delta S_A$, $\Delta S_B$, and $\Delta S_C$ are determined. **Fig. 10F** illustrates respective plots for $\Delta S_A$, $\Delta S_B$, and $\Delta S_C$. From Fig. 10F it is evident that $\Delta S_A < \Delta S_C$ and $\Delta S_B < \Delta S_C$.

In the following step S332, it is determined whether the condition

$$|V_0| > K7 * V_{rated} \ OR \ |I_0| > K8 * I_{rated}$$

is met. Here, for illustrative purposes, K7 is set as 0.02, and K8 is set as 0.15. As can be seen in Fig. 10C, the above condition for $|V_0|$ is met, since K7 is set as 0.02 and hence smaller than K3 in Fig. 10C, which is set as 0.05. Alternatively, the above condition for $|I_0|$ is also met, since K8 is set as 0.015 and hence identical to K4 in Fig. 10C.

Consequently, the process proceeds to any one of steps S333a to S333f. As shown in Fig. 10F, $\Delta S_A < \Delta S_C$ and $\Delta S_B < \Delta S_C$ is determined. **Fig. 10G** illustrates respective plots for $\delta_V^+$. As can be seen, $\delta_V^+$ is in the range of ([-30°,90°]). Hence, the conditions of step S333d are met, and the fault is classified as an AB-g fault.

An example case 6 demonstrates the above specified switching process and magnitude-angle-based and angle-based process for an ABC-g fault at 30% of the distance from node M to node N.

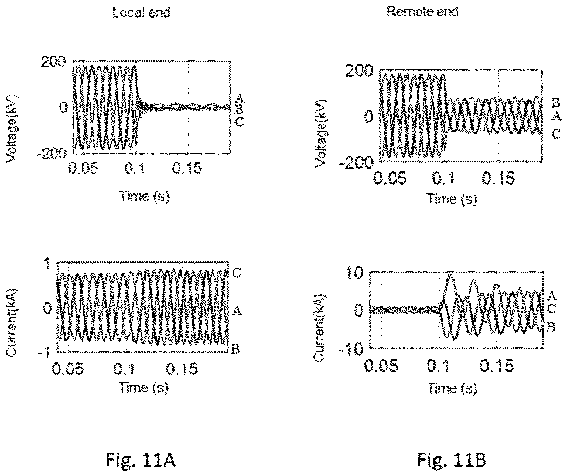

In step S100, voltage and current signals are obtained. **Fig. 11A** illustrates the obtained signals at a local end, i.e., an end of the transmission line at/near the power source 16 as illustrated in Fig. 1. **Fig. 11B** illustrates the obtained signals at a remote end, i.e., and end of the transmission line at/near the power grid 10.

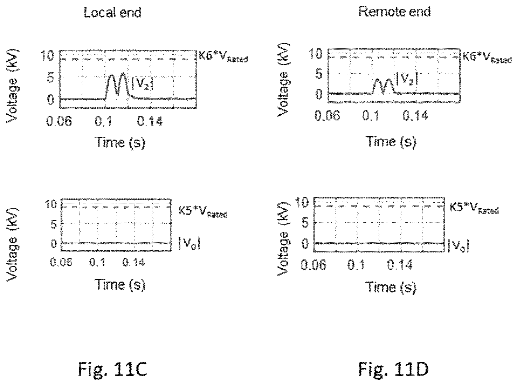

In step S110, sequence components of the obtained signals are determined. **Fig. 11C** illustrates the determined magnitude of the negative-sequence voltage and the magnitude of the zero-sequence voltage at the local end, and **Fig.11D** illustrates the determined magnitude of the negative-sequence voltage and the magnitude of the zero-sequence voltage at the remote end.

In step S120, it is determined whether the conditions for an ABC-g fault as illustrated in the flow chart of Fig. 3 is met. $|V_{rated}|$ may, for illustrative purposes, be 220 kV for this case. From Figs. 11C and 11D it can be seen that the condition of

$$|V_0| < K5 * |V_{rated}| \ AND \ |V_2| < K6 * |V_{rated}|$$

is met. Here, for illustrative purposes, scalar factors K5 and K6 are set as 0.02. $V_2$, $V_0$ are respectively shown as solid lines, and $K6 * V_{rated}$ and $K5 * V_{rated}$ are respectively shown as dashed lines in Figs. 11C and 11D. Hence, the process proceeds to step S130, where the fault is classified as an ABC-g fault.

In the above-described examples and embodiments, scalar factors K1 to K8 may be set according to a user's requirements. Generally, any one of K1 to K8 may be set within a range from larger than 0 to 1, preferably from larger than 0 to 0.5, more preferably from larger than 0 to 0.25, even more preferably from larger than 0 to 0.1. Moreover, scalar factors K1 to K8 may be set to be the same or at least some or all scalar factors may be different to each other.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any one of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

**List of references**

[1] Relion® 670 SERIES Line distance protection, REL670 Version 2.2, ANSI Technical manual, July 2021

[2] B. Kasztenny, B. Campbell, and J. Mazereeuw, "Phase selection for single-pole tripping - Weak infeed conditions and cross-country faults," GE Power Management, Markham, ON, Canada, Oct. 2000.

[3] J. B. Roberts and E. O. Schweitzer, III, "Fault identification system for use in protective relays for power transmission lines," US5515227A, May 1996.

[4] S. Paladhi and A. K. Pradhan, "Adaptive Fault Type Classification for Transmission Network Connecting Converter-Interfaced Renewable Plants," in IEEE Systems Journal, vol. 15, no. 3, pp. 4025-4036, Sept. 2021, doi: 10.1109/JSYST.2020.3010343.

[5] T. Adu, "An accurate fault classification technique for power system monitoring devices," IEEE Trans. Power Del., vol. 17, no. 3, pp. 684-690, Nov. 2002.

[6] L. Yang, "Fault type classification algorithm," U.S. Patent "US005783946A", Jul. 21, 1998.

**Claims**

1. Method for determining a faulted phase on a power transmission line, the method comprising:

   obtaining a voltage signal and a current signal of the transmission line;
   selecting, based on a magnitude of the voltage signal and a magnitude of the current signal, a process for determining a faulted phase from a group of processes; and
   determining a faulted phase using the selected process.

2. The method according to claim 1, wherein selecting the process for determining a faulted phase is further based on phase angles of the voltage signal.

3. The method according to any one of claims 1 to 2, wherein the group of processes comprises a magnitude-angle-based process that is based on phase angles and magnitudes of the voltage and current signal and an angle-based process that is based on phase angles of the voltage signal.

4. The method according to claim 3, wherein the angle-based process is selected based on:

   an angle between the negative- and zero-sequence voltage of the voltage signal and the magnitude of a zero-sequence voltage of the voltage signal, or
   an angle between the negative-and zero-sequence voltage of the voltage signal, the magnitude of a zero-sequence, negative sequence voltage of the voltage signal and zero sequence current of the current signal.

5. The method according to claim 4, wherein the angle-based process is selected from a group comprising a first angle-based process for determining ground faults and a second angle-based process for phase-to-phase faults.

6. The method according to claim 5, further comprising:

   determining whether a first condition including or consisting of the following is met:

$$-30<\delta_V^0<30,$$

   or

$$-150<\delta_V^0<-90,$$

   or

$$90<\delta_V^0<150 \text{ and } |V_0|>K1*V_{rated},$$

   wherein

$$\delta_V^0 = \angle V_2 - \angle V_0;$$

and

selecting the first angle-based process when it is determined that the first condition is met.

7. The method according to any one of claims 5 to 6, further comprising:

   determining whether a second condition including or consisting of the following is met:

$$|V_2| > K2*V_{rated},$$

   and

$$|V_0| < K3*V_{rated},$$

   and

$$|I_0| < K4*I_{rated};$$

   and
   selecting the second angle-based method when it is determined that the second condition is met.

8. The method according to claim 7, wherein determining whether the second condition is met is performed when it is determined that the first condition is not met.

9. The method according to any one of claims 3 to 8, further comprising:

   determining whether a third condition is met; and
   selecting the magnitude-angle-based process when it is determined that the third condition is met.

10. The method according to claim 9 and any one of claims 6 to 7, wherein it is determined that the third condition is met when it is determined that the second condition is not met.

11. The method according to any one of claims 1 to 10, wherein all phases are determined as faulted phases when a fourth condition including or consisting of the following is met:

$$|V_0| < K5*|V_{rated}|,$$

   and

$$|V_2| < K6*|V_{rated}|.$$

12. The method according to any one of claims 3 to 11, wherein the magnitude-angle-based process for determining a faulted phase on a power transmission line further comprises:

   determining a change in the magnitude of the apparent power, $\Delta S$, for each phase based on the voltage and current signal;
   determining a fault voltage angle;
   determining a faulted phase based on $\Delta S$ and the fault voltage angle.

13. Computer program product comprising instructions which, when executed by a processor of computer, cause the computer to carry out the method of any one of claims 1 to 12.

14. Non-transitory computer-readable medium comprising a computer program product according to claim 13.

15. Apparatus comprising:

a processor; and
a non-transitory computer-readable medium according claim 14.

Fig. 1

S100

obtaining a voltage signal and a
current signal of the transmission
line

Select a
first angle-based process

S200

selecting, based on a magnitude of
the voltage signal and a magnitude
of the current signal, a process for
determining a faulted phase from a
group of processes

Select a second
angle-based process

Select a magnitude-angle-based
process

S300

determine a faulted phase using the
selected process.

Fig. 2

Acquire voltage and current signals — S100

Determine sequence components for voltage and current signals — S110

If $|V_0| < K5*|V_{rated}|$ AND $|V_2| < K6*|V_{rated}|$ — S120

Yes

S130 — ABC-g fault

NO

Determine $\delta_V^+ = \angle V_2 - \angle \Delta V_1$, $\delta_V^0 = \angle V_2 - \angle V_0$, $\Delta V_1 = V_1^f - V_1^{pre}$ — S201

S210 — If $((-30 < \delta_V^0 < 30)$ OR $(-150 < \delta_V^0 < -90)$ OR $(90 < \delta_V^0 < 150))$ AND $|V_0| > K1*V_{rated}$

NO

S220 — If $(|V_2| > K2*V_{rated})$ AND $(|V_0| < K3*V_{rated})$ AND $|I_0| < K4*I_{rated}$ — S230

Yes

Yes

NO

S310 — Angle-based process for ground faults

S320 — Angle-based process for phase-phase faults

S330 — Magnitude-angle-based process

Fig. 3

If $(-30<\delta_V^0<30)$ AND $(-90<\delta_V^+<30)$ A-g fault — S311

If $(-150<\delta_V^0<-90)$ AND $(30<\delta_V^+<150)$ B-g fault — S312

If $(90<\delta_V^0<150)$ AND $((-180<\delta_V^+<-90)$ OR $(150<\delta_V^+<180))$ C-g fault — S313

If $(90<\delta_V^0<150)$ AND $(-30<\delta_V^+<90)$ AB-g fault — S314

If $(-30<\delta_V^0<30)$ AND $((-180<\delta_V^+<-150)$ OR $(90<\delta_V^+<180))$ BC-g fault — S315

If $(-150<\delta_V^0<-90)$ AND $(-150<\delta_V^+<-30)$ CA-g fault — S316

Fig. 4A

If $(-30<\delta_V^+<90)$ AB fault — S321

If $(-180<\delta_V^+<-150)$ OR $(90<\delta_V^+<180)$ BC fault — S322

If $(-150<\delta_V^+<-30)$ CA fault — S323

Fig. 4B

**Fig. 5**

Fig. 6A

Fig. 6B

Fig. 6C

Fig. 6D

Fig. 7A

Fig. 7B

EP 4 752 572 A1

Fig. 7D

Fig. 7C

24

Fig. 8A

Fig. 8B

Fig. 8C

Fig. 8D

Fig. 9A                    Fig. 9B

Fig. 9C

Fig. 9D

Fig. 9E

Fig. 9F

Local end

Remote end

Fig. 10A

Fig. 10B

Local end

Remote end

Fig. 10C

Fig. 10D

Fig. 10E

Fig. 10F

Fig. 10G

Fig. 11A

Fig. 11B

Local end

Remote end

Fig. 11C

Fig. 11D

## EUROPEAN SEARCH REPORT

**Application Number**

EP 24 21 6870

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 661 664 A (NOVOSEL DAMIR [US] ET AL) 26 August 1997 (1997-08-26) | 1,2,11, 13-15 | INV. G01R31/08 |
| A | * figure 3A * <br> * claim 1 * <br> * column 6, line 41 - column 7, line 60 * | 3-10,12 | |
| X | US 2003/074146 A1 (STOUPIS JAMES D [US] ET AL) 17 April 2003 (2003-04-17) | 1,11, 13-15 | |
| A | * figures 3A-7B * <br> * claim 18 * <br> * paragraph [0113] - paragraph [0117] * | 2-10,12 | |
| A | CN 107 238 780 A (SUQIAN POWER SUPPLY COMPANY OF STATE GRID JIANGSU ELECTRIC POWER COMPA) 10 October 2017 (2017-10-10) <br> * the whole document * | 1-15 | |
| A | US 2016/299187 A1 (LIANG XIAODONG [CA] ET AL) 13 October 2016 (2016-10-13) <br> * the whole document * | 1-15 | |

**TECHNICAL FIELDS SEARCHED (IPC)**

G01R

The present search report has been drawn up for all claims

| Place of search | Date of completion of the search | Examiner |
|---|---|---|
| Munich | 13 May 2025 | Nguyen, Minh |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 6870

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2025

| Patent document cited in search report | | Publication date | Patent family member(s) | | Publication date |
|---|---|---|---|---|---|
| US 5661664 | A | 26-08-1997 | CA | 2184091 A1 | 08-09-1995 |
| | | | US | 5661664 A | 26-08-1997 |
| | | | WO | 9524014 A2 | 08-09-1995 |
| US 2003074146 | A1 | 17-04-2003 | DE | 10297214 T5 | 26-08-2004 |
| | | | US | 2003074146 A1 | 17-04-2003 |
| | | | WO | 03023426 A1 | 20-03-2003 |
| CN 107238780 | A | 10-10-2017 | NONE | | |
| US 2016299187 | A1 | 13-10-2016 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2024068103 A1
- US 5515227 A
- US 005783946 A, L. Yang

**Non-patent literature cited in the description**

- **B. KASZTENNY** ; **B. CAMPBELL** ; **J. MAZEREEUW**. Phase selection for single-pole tripping - Weak infeed conditions and cross-country faults. *GE Power Management*, October 2000
- **J. B. ROBERTS** ; **E. O. SCHWEITZER, III**. *Fault identification system for use in protective relays for power transmission lines*
- **S. PALADHI** ; **A. K. PRADHAN**. Adaptive Fault Type Classification for Transmission Network Connecting Converter-Interfaced Renewable Plants. *IEEE Systems Journal*, September 2021, vol. 15 (3), 4025-4036
- **T. ADU**. An accurate fault classification technique for power system monitoring devices. *IEEE Trans. Power Del.*, November 2002, vol. 17 (3), 684-690